# EUROPEAN PATENT APPLICATION

(11) **EP 3 428 975 A1**
(43) Date of publication of application: **16.01.2019**
(21) Application number: 17181486.6
(22) Date of filing: 14.07.2017
(51) Int. Cl.: H01L 33/00, H01L 33/02

(54) **LIGHT-EMITTING DEVICES HAVING AN ANTIREFLECTIVE SILICON CARBIDE OR SAPPHIRE SUBSTRATE AND METHODS OF FORMING THE SAME**

(71) Applicant: AGC Glass Europe, 1348 Louvain-La-Neuve (BE); AGC Glass Company North America, Alpharetta GA 30022-1167 (US); Asahi Glass Co., Ltd., Chiyoda-ku Tokyo 100-8405 (JP); AGC Vidros do Brasil Ltda, CEP 12523-671 Guaratinguetá São Paulo (BR)
(72) Inventor: VENTELON, Lionel, 1400 Nivelles (BE); BOULANGER, Pierre, 4218 Couthuin (BE)
(74) Representative: Agustsson, Sveinn Otto

(57) **Abstract**

A light-emitting device includes a substrate that is at least partially transparent to optical radiation and has a first index of refraction. A diode region is disposed on a first surface of the substrate and is configured to emit light responsive to a voltage applied thereto. An encapsulation layer is disposed on a second surface of the substrate and has a second index of refraction. An antireflective layer stack is formed within the substrate directly below the second surface of the. The antireflective layer has an amorphous non-porous first layer, a porous second layer, an amorphous non porous third layer and a fourth layer with modified crystallinity. The encapsulation layer may also be omitted and the substrates second surface may separate the substrate, which has an antireflective layer stack within the substrate, directly below the second substrate surface, from air.

## Description

### Summary of invention

The present invention relates generally to microelectronic devices and fabrication methods therefor, and, more particularly, to light-emitting devices and fabrication methods therefor.

Light-emitting diodes (LEDs) are widely used in consumer and commercial applications. As is well known to those skilled in the art, a light-emitting diode generally includes a diode region on a microelectronic substrate. The microelectronic substrate may comprise, for example, gallium arsenide, gallium phosphide, alloys thereof, silicon carbide, and/or sapphire. Continued developments in LEDs have resulted in highly efficient and mechanically robust light sources that can cover the visible spectrum and beyond. These attributes, coupled with the potentially long service life of solid state devices, may enable a variety of new display applications, and may place LEDs in a position to compete with well entrenched incandescent and fluorescent lamps.

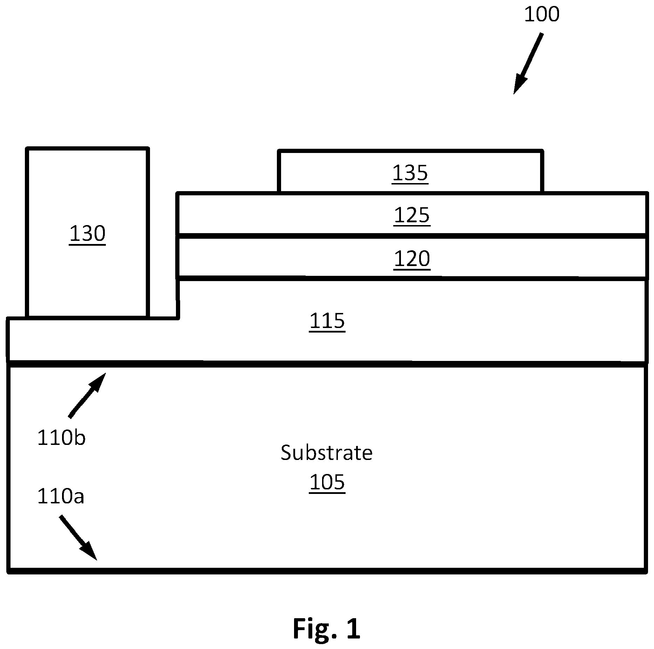

Referring now to FIG. 1, a conventional GaN-based LED 100 comprises a silicon carbide or sapphire substrate 105 that has first and second opposing surfaces 110a and 110b, respectively, and is at least partially transparent to optical radiation. A diode region, comprising an n-type layer 115, an active region 120, and a p-type layer 125 is disposed on the second surface 110b and is configured to emit optical radiation into the substrate 105 upon application of a voltage across the diode region, for example across ohmic contacts 130 and 135.

The diode region including the n-type layer 115, the active region 120, and/or the p-type layer 125 may comprise gallium nitride-based semiconductor layers, including alloys thereof, such as indium gallium nitride and/or aluminium indium gallium nitride. The fabrication of gallium nitride on silicon carbide is known to those skilled in the art, and is described, for example, in U.S. Patent 6,177,688 . It will also be understood that a buffer layer or layers comprising aluminium nitride, for example, may be provided between the n-type gallium nitride layer 115 and the substrate 105, as described in U.S. Patents 5,393,993, 5,523,589, 6,177,688.

The active region 120 may comprise a single layer of n-type, p-type, or intrinsic gallium nitride-based materials, another homostructure, a single heterostructure, a double heterostructure, and/or a quantum well structure, all of which are well known to those skilled in the art. Moreover, the active region 120 may comprise a light-emitting layer bounded by one or more cladding layers. The n-type gallium nitride layer 115 may comprise silicon-doped gallium nitride, while the p-type gallium nitride layer 125 may comprise magnesium-doped gallium nitride. In addition, the active region 120 may include at least one indium gallium nitride quantum well.

In some LEDs, the ohmic contact 135 for the p-type gallium nitride layer 125 comprises platinum, nickel and/or titanium/gold. In other LEDs, a reflective ohmic contact comprising, for example, aluminium and/or silver, may be used. The ohmic contact 130 to the n-type gallium nitride layer 115 may comprise aluminium and/or titanium. Other suitable materials that form ohmic contacts to p-type gallium nitride and n-type gallium nitride may be used for ohmic contacts 135 and 130, respectively. Examples of ohmic contacts to n-type gallium nitride layers and p-type gallium nitride layers are described, for example, in U.S. Patent 5,767,581 .

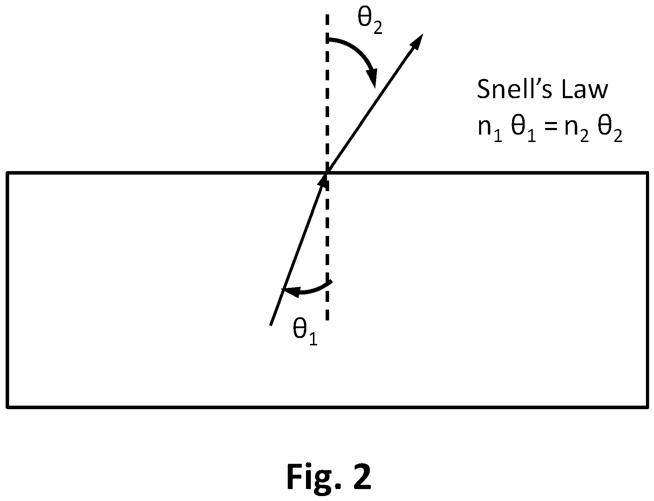

Unfortunately, the majority of light that is generated inside of a LED device typically never escapes the device because of various optical losses, such as total internal reflection (TIR). Referring now to FIG.2 , when light travels from one medium to another, it may be refracted such that the angle of refraction is governed by Snell's law as follows: n₁sinθ₁= n₂sinθ₂, where n₁ is the index of refraction for medium 1 and n₂ is the index of refraction for medium 2. The light that escapes, however, has an angular dependence that is less than the "critical angle," which is defined as follows θ _{1critical} = sin⁻¹(n₂/n₁). Light that is incident at an angle greater than the critical angle does not pass through to medium 2, but is instead reflected back into medium 1. This reflection is commonly called total internal reflection. Thus, mediums having significantly different indices of refraction may result in a relatively small critical angle for light transmitted through the two mediums and may result in significant optical loss due to total internal reflection.

GB-A-1136218 discloses a light-emitting diode mounted on one side of a gallium arsenide substrate, another side of the substrate having thereon an antireflective coating that may have a graded refractive index. This may comprise multiple layers, and may include a layer of graded composition such as a mixture of silica and another metal oxide such as titanium oxide.

US-A-2002/0140879 discloses a display device including a light-extraction layer, in the form of a transparent substrate with an antireflective layer arranged thereon.

EP1618614 A1 discloses a light-emitting device comprising a silicon carbide or sapphire substrate having a first surface, a second surface, and a first index of refraction, a diode region on the first surface of the substrate that is configured to emit light responsive to a voltage applied thereto; and an antireflective layer on the second surface of the substrate that has a graded index of refraction and that comprises (SiC)ₓ(SiO₂)₁₋ₓ or (Al₂O₃)ₓ(SiO₂)₁₋ₓ.

The present invention provides a light-emitting device comprising:
- a substrate of crystalline silicon carbide or sapphire that is at least partially transparent to optical radiation and has a first surface, a second surface, and a first index of refraction;
- a diode region on the first surface of the substrate that is configured to emit light responsive to a voltage applied thereto; and
- characterized in that the substrate comprises an antireflective layer stack within the substrate, directly beneath the second surface of the substrate, that has an overall index of refraction having values in a range between the first index of refraction of the substrate bulk and a second index of refraction associated with a medium adjacent to a second surface of the antireflective layer, the medium consisting of an encapsulation material or air.

Advantageously, by using the antireflective layer stack of the present invention to transition between a first medium, i.e., the substrate bulk, and a second medium, i.e., the encapsulation material or air, abrupt index of refraction changes may be avoided, which may reduce the amount of light reflected internally at boundaries of the substrate and/or the encapsulation material.

In some embodiments, the substrate may comprise SiC with, in the bulk substrate, an index of refraction of about 2.6 and the encapsulation material has an index of refraction of about 1.5. The substrate may also comprise Al₂O₃, in particular sapphire, with, in the bulk substrate, an index of refraction of about 1.8 and the encapsulation material has an index of refraction of about 1.5. for the purposes of the present invention the refractive indexes are considered at a wavelength of 550 nm.

The antireflective layer stack that is within the substrate, directly beneath the second surface of the substrate, comprises several layers. Starting from the second substrate surface the antireflective layer stack comprises in sequence: a first layer, a second layer, an optional third layer and a fourth layer. The first layer is an amorphous non-porous layer, the second layer is a porous layer, the third layer is an amorphous non-porous layer, and the fourth layer is a partially crystalline layer.

The solid material forming the antireflective layer stack consists essentially of the same material as the substrate bulk, that is it preferably consists essentially of silicon carbide or Al₂O₃. Thus the substrate bulk and the antireflective layer stack are part of the same substrate. Below the partially crystalline layer there is crystalline bulk substrate. The pores of the porous layer are filled with a gas. Ions formed of the same gas are to be found throughout the solid material of all layers of the antireflective layer stack.

The antireflective layer stack may be formed within the substrate, directly beneath the second surface of the substrate, using an ion implantation process on the second substrate surface. Particularly cations of O, Ar, N, or He are used in the implantation process. A mixture of any two or more of the cations of of O, Ar, N, and/or He may also be used.

In particular embodiments the pores of the porous layer of the antireflective layer stack of the present invention comprise O₂, Ar, N₂, or He, and ions of O, Ar, N, or He are to be found respectively throughout the solid material of all layers of the antireflective layer stack.

### Brief description of drawings

Other features of the present invention will be more readily understood from the following detailed description of specific embodiments thereof when read in conjunction with the accompanying drawings, in which:
- FIG. 1 is a cross-sectional diagram that illustrates a conventional GaN-based light-emitting diode (LED);
- FIG. 2 is a cross-sectional diagram that illustrates light traveling between two mediums having different indices of refraction;
- FIG. 3 is a cross-sectional diagram that illustrates light-emitting devices and fabrication methods therefor, in accordance with some embodiments of the present invention;
- FIG. 4 is schematic representation of a TEM cross section of an antireflective layer stack of the present invention, formed within a substrate directly below the 2nd substrate surface; and
- FIG. 5 is a flowchart that illustrates exemplary operations for fabricating light-emitting devices, in accordance with some embodiments of the present invention.

### Description of embodiments

While the invention is susceptible to various modifications and alternative forms, specific embodiments thereof are shown by way of example in the drawings and will herein be described in detail. It should be understood, however, that there is no intent to limit the invention to the particular forms disclosed, but on the contrary, the invention is to cover all modifications, equivalents, and alternatives falling within the spirit and scope of the invention as defined by the claims. Like numbers refer to like elements throughout the description of the figures. In the figures, the dimensions of layers and regions are exaggerated for clarity. Each embodiment described herein also includes its complementary conductivity type embodiment.

It will be understood that when an element such as a layer, region or substrate is referred to as being "on" another element, it can be directly on the other element or intervening elements may also be present. It will be understood that if part of an element, such as a surface, is referred to as "inner," it is farther from the outside of the device than other parts of the element. Furthermore, relative terms such as "beneath" or "overlies" may be used herein to describe a relationship of one layer or region to another layer or region relative to a substrate or base layer as illustrated in the figures. It will be understood that these terms are intended to encompass different orientations of the device in addition to the orientation depicted in the figures. Finally, the term "directly" means that there are no intervening elements. As used herein, the term "and/or" includes any and all combinations of one or more of the associated listed items.

It will be understood that, although the terms first, second, etc. may be used herein to describe various elements, components, regions, layers and/or sections, these elements, components, regions, layers and/or sections should not be limited by these terms. These terms are, unless otherwise noted, only used to distinguish one element, component, region, layer or section from another region, layer or section. Thus, a first region, layer or section discussed below could be termed a second region, layer or section, and, similarly, a second without departing from the teachings of the present invention.

Examples of light-emitting devices that may be used in embodiments of the present invention include, but are not limited to, the devices described in the following U. S. Patent Nos.: 6,201,262 , 6,187,606 , 6,120,600 , 5,912,477 , 5,739,554 , 5,631,190 , 5,604,135 , 5,523,589 , 5,416,342 , 5,393,993 , 5,338,944 , 5,210,051 , 5,027,168 , 5,027,168 , 4,966,862 and/or 4,918,497 , the disclosures of which are incorporated herein by reference. Other suitable LEDs and/or lasers are described in United States Patent Application Serial No. 10/140,796, entitled "GROUP III NITRIDE BASED LIGHT EMITTING DIODE STRUCTURES WITH A QUANTUM WELL AND SUPERLATTICE, GROUP III NITRIDE BASED QUANTUM WELL STRUCTURES AND GROUP III NITRIDE BASED SUPERLATTICE STRUCTURES", filed May 7, 2002 , as well as United States Patent Application Serial No. 10/057,821, filed January 25, 2002 entitled "LIGHT EMITTING DIODES INCLUDING SUBSTRATE MODIFICATIONS FOR LIGHT EXTRACTION AND MANUFACTURING METHODS THEREFOR" the disclosures of which are incorporated herein as if set forth fully. Furthermore, phosphor coated LEDs, such as those described in United States Patent Application Serial No. 10/659,241 entitled "PHOSPHOR-COATED LIGHT EMITTING DIODES INCLUDING TAPERED SIDEWALLS, AND FABRICATION METHODS THEREFOR," filed September 9, 2003 , the disclosure of which is incorporated by reference herein as if set forth full, may also be suitable for use in embodiments of the present invention.

The LEDs and/or lasers may be configured to operate in a "flip-chip" configuration such that light emission occurs through the substrate. In such embodiments, the substrate may be patterned so as to enhance light output of the devices as is described, for example, in United States Patent Application Serial No. 10/057,821, filed January 25, 2002 entitled "LIGHT EMITTING DIODES INCLUDING SUBSTRATE MODIFICATIONS FOR LIGHT EXTRACTION AND MANUFACTURING METHODS THEREFOR" the disclosure of which is incorporated herein by reference as if set forth fully herein.

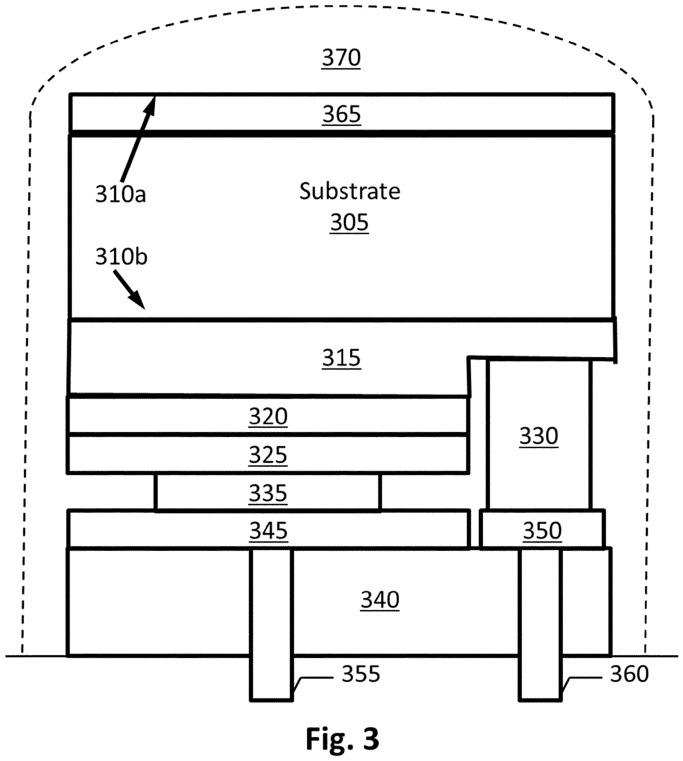

Referring now to FIG. 3, a light-emitting device 300, in accordance with some embodiments of the present invention, is illustrated. The light-emitting device 300 comprises a GaN-based LED similar to the GaN LED described above with respect to FIG. 1. Shown in a flip-chip configuration in FIG. 3, the GaN-based LED comprises a substrate 305 that has first and second opposing surfaces 310a and 310b, respectively, and is at least partially transparent to optical radiation. The substrate 305 may be, for example, but is not limited to, a SiC substrate or a sapphire (Al₂O₃) substrate. A diode region, comprising an n-type layer 315, an active region 320, and a p-type layer 325 is disposed on the second surface 310b and is configured to emit optical radiation into the substrate 305 upon application of a voltage across the diode region, for example across ohmic contacts 330 and 335.

The diode region including the n-type layer 315, the active region 320, and/or the p-type layer 325 may comprise gallium nitride-based semiconductor layers, including alloys thereof, such as indium gallium nitride and/or aluminium indium gallium nitride. The fabrication of gallium nitride on silicon carbide is described, for example, in the above-incorporated U.S. Patent 6,177,688. A buffer layer or layers comprising aluminium nitride, for example, may be provided between the n-type gallium nitride layer 315 and the silicon carbide substrate 305, as described in the above-incorporated U.S. Patents 5,393,993 , 5,523,589 , 6,177,688.

The active region 320 may comprise a single layer of n-type, p-type, or intrinsic gallium nitride-based materials, another homostructure, a single heterostructure, a double heterostructure, and/or a quantum well structure. Moreover, the active region 320 may comprise a light-emitting layer bounded by one or more cladding layers. The n-type gallium nitride layer 315 may comprise silicon-doped gallium nitride, while the p-type gallium nitride layer 325 may comprise magnesium-doped gallium nitride. In addition, the active region 320 may include at least one indium gallium nitride quantum well.

In some embodiments, the ohmic contact 335 for the p-type gallium nitride layer 325 comprises platinum, nickel and/or titanium/gold. In other embodiments, a reflective ohmic contact comprising, for example, aluminium and/or silver, may be used. The ohmic contact 330 to the n-type gallium nitride layer 315 may comprise aluminium and/or titanium. Other suitable materials that form ohmic contacts to p-type gallium nitride and n-type gallium nitride may be used for ohmic contacts 335 and 330, respectively. Examples of ohmic contacts to n-type gallium nitride layers and p-type gallium nitride layers are described, for example, in the above-incorporated U.S. Patent 5,767,581.

The LED is shown in flip-chip or upside-down configuration mounted on a mounting support 340, such as a heat sink, using bonding regions 345 and 350. The bonding regions 345 and 350 may include solder preforms that are attached to the diode region and/or the mounting support 340, and that can be reflowed to attach the ohmic contacts 335 and 330 to the mounting support 340 using conventional solder reflowing techniques. Other embodiments of bonding regions 345 and 350 may comprise gold, indium, and/or braze. An anode lead 355 and a cathode lead 360 may be provided for external connections.

As also shown in FIG. 3, the flip-chip or upside-down packing configuration places the substrate 305 away from the mounting support 340 and places the diode region down, adjacent to the mounting support 340. A barrier region (not shown) may be included between the ohmic contacts 335, 330 and the bonding regions 345, 350. The barrier region may comprise nickel, nickel/vanadium, and/or titanium/tungsten. Other barrier regions may also be used.

In accordance with some embodiments of the present invention, an antireflective layer stack 365 is formed within the substrate, directly beneath the second substrate surface 310a and has an index of refraction that assumes values in a range between about a first index of refraction associated with a first medium that is adjacent thereto (i.e., the substrate bulk 305) and a second index of refraction associated with a second medium that is adjacent thereto. In accordance with various embodiments of the present invention, the second medium may be air or an encapsulation material 370 as shown in FIG. 3.

Thus, in accordance with some embodiments of the present invention, the antireflective layer stack has an intermediate index of refraction that assumes values in a range between two different indices of refraction associated with different optical transmission mediums. Advantageously, by using the antireflective layer stack to transition between the different mediums, abrupt index of refraction changes may be avoided, which may reduce the amount of light reflected internally at boundaries of one or both of the mediums.

According to the present invention the antireflective layer stack may be formed within the substrate, beneath and closest to the second surface of the substrate, using an ion implantation process comprising the following operations:

After or before forming a diode region on the first surface of the substrate that is configured to emit light responsive to a voltage applied thereto, the antireflective layer stack may be formed within the substrate, beneath and closest to the second surface of the substrate, using an ion implantation process comprising the following operations.
- providing a first source gas selected among O₂, Ar, N₂ and He,
- ionizing the first source gas so as to form a first mixture of single charge ions and multicharge ions O, Ar, N, or He,
- accelerating the first mixture of single charge ions and multicharge ions with a first acceleration voltage so as to form a first beam comprising a mixture of single charge ions and multicharge ions, wherein the firs acceleration voltage is comprised between 15 and 60 kV, and
- positioning the second substrate surface in the trajectory of the first beam so as to obtain a first ion dosage comprised between 10¹⁷ ions/cm² and 10¹⁸ ions/cm²,

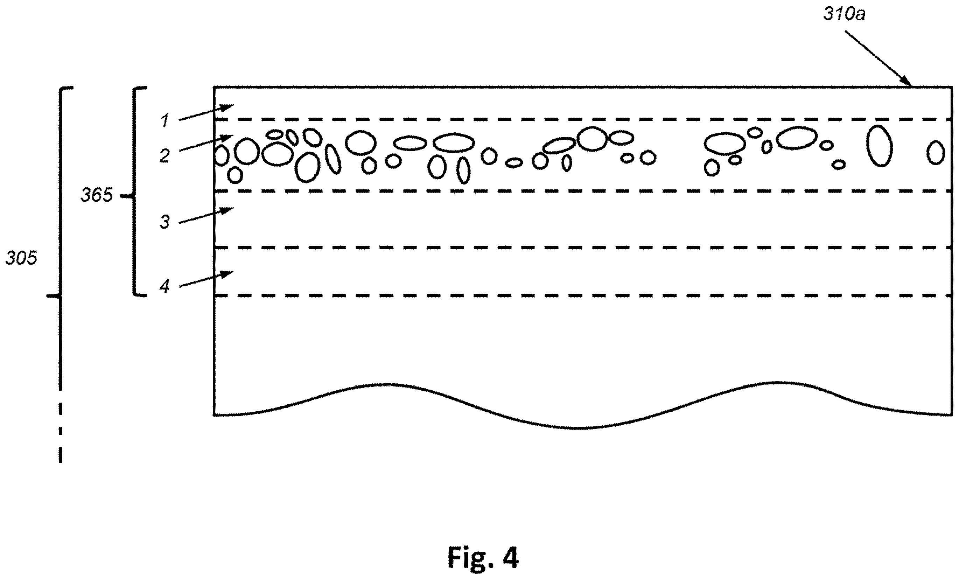

The inventors have surprisingly found, that with the ion implantation process of the present invention providing an ion beam comprising a mixture of single charge and multicharge ions of N, O, Ar, or He, accelerated with the same specific acceleration voltage and at such specific dosage, applied to a sapphire or silicon carbide substrate, lead to a substrate having an antireflective layer stack within the substrate, beneath and closest to the implanted substrate surface. As illustrated in FIG. 4, the resulting substrate (305) has, starting from the second substrate surface (310a) a first layer which is a non-porous amorphous layer (1), a second layer which is a porous layer (2), a third layer which is an amorphous non-porous layer (3), and fourth layer which is a partially crystalline layer (4). The pores of the porous layer are filled with the gas formed by recombination of the implanted ions. Implanted ions formed from the same gas are to be found throughout the solid material of all layers of the antireflective layer stack at a concentration of less than 10 atom %. Contrary to what is observed for soda lime glass there is only one detectable porous layer. Preferably the relative concentration C of implanted species in the different layers 1 to 4 is as follows: C(layer 2) > C(layer 1) ∼ C(layer 3) > C(layer 4).

Preferably the mixture of single charge and multicharge ions is formed using an Electron Cyclotron Resonance ion source (RCE).

It appears that due to the porous layer, the antireflective layer stack reduces the scratch resistance of the substrate. This is somewhat mitigated by the presence of the first non-porous amorphous layer that forms a relatively dense and thus protecting layer on top of the porous layer and prevents the appearance of open pores at the second substrate surface.

The implantation process of the present invention leads, depending on the concentration of ions at certain depths, to partial loss of crystallinity, to amorphisation and to formation of pores, accompanied by reduction of the refractive index compared to the crystalline substrate bulk. Preferably the relative refractive index N of the different layers 1 to 4 is as follows: N(layer 2) < N(layer 1) ∼ N(layer 3) < N(layer 4). The inventors estimate that the refractive index is lower with higher amounts of implanted ions. In particular, the sequence of the porous layer, the amorphous porous third layer and the partially crystalline fourth layer, that lie in between the substrate bulk and the first amorphous layer, form a sequence of increasing refractive index from the second substrate surface towards the substrate bulk.

The refractive index of the amorphous non-porous first layer is higher than the refractive index of the porous layer, however the thickness of this layer is lower than the thickness of the other three layers, therefore its impact on the reflectance is kept relatively low, while still being sufficient to somewhat protect the more sensitive porous layer. Preferably the geometrical thickness of the first porous layer is less than the geometrical thickness of each of the other layers of the antireflective layer stack, that is of the porous second layer, of the amorphous non-porous third layer and of the partially crystalline fourth layer. Preferably the geometrical thickness of the first amorphous non-porous layer is less than 30% of the geometrical thickness of the porous layer. More preferably the geometrical thickness of the first amorphous non-porous layer is less than 20% of the geometrical thickness of the porous layer.

The ion source gas chosen among O₂, Ar, N₂ and He is ionized so as form a mixture of single charge ions and multi charge ions of O, Ar, N, or He respectively. The mixture of single charge ions and multicharge ions is accelerated with an acceleration voltage so as to form a beam comprising a mixture of single charge ions and multicharge ions. This beam may comprise various amounts of the different O, Ar, N, or He ions. Example currents of the respective ions are shown in Table 1 below (measured in milli Ampère). The ion source gas may also be a mixture of two or more of O₂, Ar, N₂ and He so as to form the respective mixture of single charge ions and multi charge ions of two or more of O, Ar, N, and He.

**Table 1**

| Ions of O | | Ions of Ar | | Ions of N | | Ions of He | |
|---|---|---|---|---|---|---|---|
| O⁺ | 1.35 mA | Ar⁺ | 2 mA | N⁺ | 0.55 mA | He⁺ | 1.35 mA |
| O²⁺ | 0.15 mA | Ar²⁺ | 1.29 mA | N²⁺ | 0.60 mA | He²⁺ | 0.15 mA |
| | | Ar³⁺ | 0.6 mA | N³⁺ | 0.24 mA | | |
| | | Ar⁴⁺ | 0.22 mA | | | | |
| | | Ar⁵⁺ | 0.11 mA | | | | |

The thicknesses of the layers forming the antireflective layer stack, their degree of amorphisation and the porosity of the porous layer are controlled, for a given substrate, by choosing the appropriate ion implantation treatment parameters. For a given ion source gas, the key ion implantation parameters are the ion acceleration voltage and the ion dosage.

The positioning of the substrate in the trajectory of the beam of single charge and multicharge ions is chosen such that certain amount of ions per surface area or ion dosage is obtained. The ion dosage is expressed as number of ions per square centimetre. For the purpose of the present invention the ion dosage is the total dosage of single charge ions and multicharge ions. The ion beam preferably provides a continuous stream of single and multicharge ions. The ion dosage is controlled by controlling the exposure time of the substrate to the ion beam. According to the present invention multicharge ions are ions carrying more than one positive charge. Single charge ions are ions carrying a single positive charge.

In one embodiment of the invention the positioning comprises moving substrate and ion implantation beam relative to each other so as to progressively treat a certain surface area of the glass substrate. Preferably they are moved relative to each other at a speed comprised between 5 mm/s and 150 mm/s and most preferably between 5 and 100 mm/s. The speed of the movement of the substrate relative to the ion implantation beam is chosen in an appropriate way to control the residence time of the sample in the beam which influences ion dosage of the area being treated.

The method of the present invention can be easily scaled up so as to treat large numbers of small substrates in one process step, for example by continuously scanning a substrate carrier carrying multiple substrates with an ion beam of the present invention or for example by forming an array of multiple ion sources that treat a moving substrate carrier over its whole width in a single pass or in multiple passes.

According to the present invention the acceleration voltage and ion dosage are preferably comprised in the following ranges:

**Table 2**

| **parameter** | **general range** | **preferred range** | **most preferred range** |
|---|---|---|---|
| Acceleration voltage [kV] | 15 to 60 | 20 to 40 | 30 to 40 |
| Total ion dosage [ions/cm²] | 10¹⁷ to 10¹⁸ | 2.5 x 10¹⁷ to 7.5 x10¹⁷ | 2.5 x 10¹⁷ to 5 x 10¹⁷ |

The inventors have found that ion sources providing an ion beam comprising a mixture of single charge and multicharge ions, accelerated with the same acceleration voltage are particularly useful as they may provide lower dosages of multicharge ions than of single charge ions. It appears that a substrate having an antireflective layer stack within the substrate, directly beneath the substrate surface, may be obtained with the mixture of single charge ions, having higher dosage and lower implantation energy, and multicharge ions, having lower dosage and higher implantation energy, provided in such a beam. Indeed this selected mix of ions leads to an implantation profile which creates a sequence of layers having increasing refractive index going from the substrate surface to the substrate bulk of silicon carbide or sapphire. The implantation energy, expressed in Electron Volt (eV) is calculated by multiplying the charge of the single charge ion or multicharge ion with the acceleration voltage.

In a preferred embodiment of the present invention the temperature of the area of the substrate being treated, situated under the area being treated is less than or equal to the melting temperature of the substrate. This temperature is for example influenced by the ion current of the beam, by the residence time of the treated area in the beam and by any cooling means of the substrate.

In a preferred embodiment of the invention only one type of implanted ions is used, the type of ion being selected among ions of N, O, or Ar. In another embodiment of the invention two or more types of implanted ions are combined, the types of ion being selected among ions of N, O, or Ar.

In one embodiment of the invention several ion implantation beams are used simultaneously or consecutively to treat the glass substrate.

In one embodiment of the invention the total dosage of ions per surface unit of an area of the substrate is obtained by a single treatment by an ion implantation beam.

In another embodiment of the invention the total dosage of ions per surface unit of an area of the substrate is obtained by several consecutive treatments by one or more ion implantation beams. Each consecutive treatment may have different process parameters.

In a preferred embodiment of the present invention, after or before forming a diode region on the first surface of the substrate that is configured to emit light responsive to a voltage applied thereto, the antireflective layer stack may be formed within the substrate, beneath and closest to the second surface of the substrate, using an ion implantation process comprising the following first operations.
- providing a first source gas selected among O₂, Ar, N₂ and He,
- ionizing the first source gas so as to form a first mixture of single charge ions and multicharge ions O, Ar, N, or He,
- accelerating the first mixture of single charge ions and multicharge ions with a first acceleration voltage so as to form a first beam comprising a mixture of single charge ions and multicharge ions, wherein the first acceleration voltage is comprised between 15 and 60 kV, and positioning the second substrate surface in the trajectory of the first beam so as to obtain a first ion dosage comprised between 10¹⁷ ions/cm² and 10¹⁸ ions/cm²,
- followed by the following second operations:
- providing a second source gas selected among O₂, Ar, N₂ and He,
- ionizing the second source gas so as to form a first mixture of single charge ions and multicharge ions O, Ar, N, or He,
- accelerating the second mixture of single charge ions and multicharge ions with a second acceleration voltage so as to form a first beam comprising a mixture of single charge ions and multicharge ions, wherein the second acceleration voltage is comprised between 15 and 60 kV, and
- positioning the second substrate surface in the trajectory of the second beam so as to obtain a second ion dosage comprised between 10¹⁷ ions/cm² and 10¹⁸ ions/cm².

In a preferred embodiment the total ion dosage obtained by a single ion implantation treatment or by multiple ion implantation treatments is comprised between 10¹⁷ ions/cm² and 10¹⁸ ions/cm².

The method of the present invention is preferably performed in a vacuum chamber at a pressure comprised between 10⁻² mbar and 10⁻⁷ mbar, more preferably at between 10⁻⁵ mbar and 10⁻⁶ mbar.

An example ion source for carrying out the method of the present invention is the Hardion+ ECR ion source from Quertech S.A.

The present invention also concerns the use of a mixture of single charge and multicharge ions to form an antireflective layer stack within the substrate directly beneath the second substrate surface of having a diode region on the first surface of the substrate that is configured to emit light responsive to a voltage applied thereto.

Ultimately the light-emitting device of the present invention, due to the antireflective layer stack formed within the substrate directly beneath the second substrate surface, has a higher light output as losses through internal reflectance of the substrate are reduced.

According to an embodiment the layers of the resulting antireflective layer stack have the following thicknesses:

**Table 3**

| | preferred thickness range [nm] | More preferred thickness range [nm] | Most preferred thickness range [nm] |
|---|---|---|---|
| amorphous non-porous first layer | 5-20 | 5-15 | 7-10 |
| porous second layer | 20-80 | 25-70 | 50-60 |
| amorphous non-porous third layer | 2-60 | 2-40 | 20-30 |
| partially crystalline fourth layer | 30-80 | 40-70 | 50-60 |

According to an embodiment of the present invention the porous second layer comprises pores having a cross-sectional equivalent circular diameter comprised between 3 and 50nm, preferably between 10 and 30nm. The cross-sectional equivalent circular diameter is determined on a TEM image of a cross section of the double porous surface layer as explained below. The lower limit of the cross-sectional equivalent circular diameter is set at 3 nm for the pores of the lower porous layer as this is the lowest diameter that can be reliably determined by this method.

According to an embodiment of the present invention the 10 to 50% of the cross-sectional area of the porous layer is occupied by pores.

Such substrates, having an antireflective layer stack within the substrate, by virtue of at least this specific combination of layers have the advantage of providing substrates that have a reduced internal reflectance, in particular at large incoming light angles, and are obtained through a process that is simple, environmentally friendly and upscaleable to large substrate carriers for large numbers of substrates. Preferably the reflectance is reduced for incoming light angles, relative to the normal of the substrate surface, comprised between 50° and 70°, more preferably comprised between 50° and 60°.

The ion types that may be implanted into these substrate are ions of O, Ar, N, or He respectively. The ions implanted are a mixture of single charge and multicharge ions. Multicharge ions are ions carrying more than one positive charge. Single charge ions are ions carrying a single positive charge. Single charge ions implanted in the glass substrate may be the single charge ions O⁺, Ar⁺, N⁺ or He⁺. Multicharge ions implanted in the glass substrate are for example O²⁺ or Ar²⁺, Ar³⁺, Ar⁴⁺ and Ar⁵⁺ or N²⁺ and N³⁺ or and He²⁺.

Preferably the mixtures of multicharge and single charge ions of O, Ar, N or He comprise respectively lower amounts of the most O²⁺ than O⁺, lower amounts of Ar²⁺, Ar³⁺, Ar⁴⁺ and Ar⁵⁺ than Ar⁺, lower amounts of N²⁺ and N³⁺ than of N⁺, lower amounts of He²⁺ than of He⁺.

In these substrates the implantation depth of the ions may be comprised between 0.1 µm and 1 µm, preferably between 0.1 µm and 0.5 µm.

The microstructure of the treated substrates, the layer thicknesses and in particular pore size and pore distribution were investigated by Transmission Electron Microscope (TEM). Cross-sectional specimens were prepared using Focused In Beam (FIB) procedure. During the preparation process carbon and platinum protective layers were deposited on top of the film. For the purpose of the present invention the two-dimensional pore sizes as determined by the present method are considered to be representative of the three-dimensional size of the pores.

The porosities were evaluated from the TEM micrographs schematically shown in FIG. 4. The images were processed with image analysis software ImageJ (developed by the National Institutes of Health, USA) to identify the pores as well-defined bright areas. The cross-sectional equivalent circular diameter of a pore, usually having an irregular shape, is the diameter of a two-dimensional disk having an equivalent area to the cross-section of the pore as determined by this image analysis method. The pore density was evaluated as the percentage of the cross-section area of the porous second layer occupied by pores.

The layer thicknesses were also evaluated on the TEM micrographs.

Detailed Description of Particular Embodiments

The ion implantation examples were prepared according to the various parameters detailed in the tables below using an RCE ion source for generating a beam of a mixture of single charge and multicharge ions. The ion source used was a Hardion+ ECR ion source from Quertech S.A.

All samples had a size of about 7 cm² and were treated on the entire surface by displacing the substrate through the ion beam at a speed selected between 10 and 100 mm/s.

The temperature of the area of the sapphire substrate being treated was kept at a temperature less than or equal to the melting temperature of the substrate.

For all examples the implantation was performed in a vacuum chamber at a pressure of 10⁻⁶ mbar.

Using the ECR ion source, and a N₂ source gas, ions of N were implanted in 1.8mm thick sapphire substrates. Before being implanted with the ion implantation method of the present invention the reflectance of the glass substrates was about 14%. The key implantation parameters can be found in table 4 below. Sample E5 was produced with two subsequent ion implantation steps.

**Table 4**

| | ion implantation treatment | | | | RL |
|---|---|---|---|---|---|
| sample number | | source gas | acceleration voltage | dosage | D65/2° |
| | | | [kV] | [ions/cm²] | [%] |
| E1 | | N₂ | 27,5 | 7 x 10¹⁶ | 11,4 |
| E2 | | N₂ | 27,5 | 8 x 10¹⁶ | 10,4 |
| E3 | | N₂ | 27,5 | 9 x 10¹⁶ | 10,2 |
| E4 | | N₂ | 27,5 | 10¹⁷ | 8,8 |
| E5 | 1^{st} | N₂ | 12,5 | 8 x 10¹⁶ | 10,0 |
| | 2^{nd} | N₂ | 27,5 | 7,2 x 10¹⁶ | |

The luminous reflectance RL is measured on the treated side with illuminant D65 and a 2° observer angle.

The thickness ranges of the layers of the antireflective layer stack in samples E1 to E5 can be found in table 5 below.

**Table 5**

| Geometrical thickness [nm] | | | |
|---|---|---|---|
| amorphous non-porous first layer | porous second layer | amorphous non-porous third layer | partially crystalline fourth layer |
| 5-15 | 20-70 | 0-40 | 40-70 |

The ranges for key pore measurements of samples E1 to E5 can be found in table 6 below.

**Table 6**

| | |
|---|---|
| Surface pore density [pores per µm²] | 15-50% |
| Average pore equivalent diameter [nm] | 5-25 |

As can be seen from the table 5 above, examples E1 to E5 of the present invention, treatment of the sapphire substrates with an ion beam comprising a mixture of single charge and multicharge ions of N, accelerated with the same specific acceleration voltage and at such specific dosage, leads to the formation of a porous surface layer in the substrate.

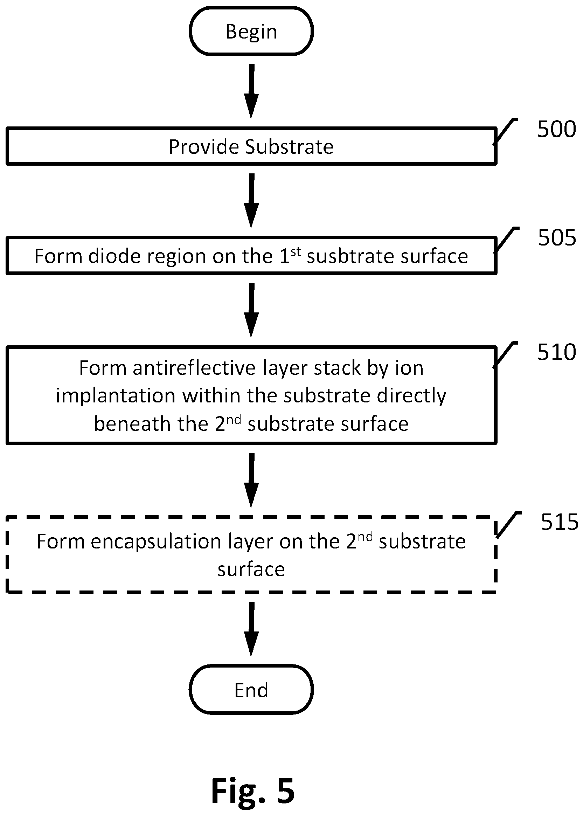

Exemplary operations for forming light-emitting devices, in accordance with some embodiments of the present invention will now be described with reference to the flowchart of FIG. 5 and the cross-sectional illustration of FIG. 3. Referring now to FIG. 5, operations begin at block 500 where a substrate 305 is provided. A diode region, i.e. layers 315, 320, and 325, is formed on the first substrate surface 310b at block 505. An antireflective layer stack 365 of the present invention, that comprises four layers is formed within the substrate directly beneath the substrate's second surface 310a at block 510. The antireflective layer stack 365 may be formed within the substrate 305 using an ion implantation process such as an single charge and multi charge ion implantation process. Optionally, the encapsulation material 370 may be formed on the second surface of the substrate at block 515.

## Claims

1. A light-emitting device (300) comprising:
a crystalline substrate comprising silicon carbide or sapphire (305) that is at least partially transparent to optical radiation and has a first surface, a second surface, and a first index of refraction;
a diode region (315) on the first surface of the substrate that is configured to emit light responsive to a voltage applied thereto; and
an antireflective layer stack (365) within the substrate directly beneath the second surface (310a) of the substrate **characterized in that** the antireflective layer stack comprises in sequence from the second substrate surface an amorphous non-porous first layer (1), a porous second layer (2), an optional amorphous non-porous third layer (3), and a fourth layer having reduced crystallinity (4).

2. The light-emitting device of claim 1 wherein the thickness of the first layer is comprised between 5 and 20m, the thickness of the second layer is comprised between 20 and 80nm, the thickness of the third layer is comprised between 2 and 60nm, and the thickness of the fourth layer is comprised between 30 and 80nm.

3. The light emitting device of any one preceding claim wherein the second layer is directly beneath the first layer, the third layer, if present, is directly beneath the second layer, and the fourth layer is directly beneath the third layer.

4. The light emitting device of any one preceding claim wherein The light-emitting device of claim 1 wherein 15 to 50% of the cross-sectional area of the porous second layer is occupied by pores.

5. The light emitting device of any one preceding claim wherein The light-emitting device of claim 1 wherein the pores of the porous second have a cross-sectional equivalent circular diameter comprised between 5 and 25 nm.

6. A method of forming a light-emitting device, comprising the following operations:
- providing a crystalline substrate comprising silicon carbide or sapphire that is at least partially transparent to optical radiation and has a first surface, a second surface, and a first index of refraction;
- forming a diode region on the first surface of the substrate that emits light responsive to a voltage applied thereto;
- forming an antireflective layer stack by ion implantation within the substrate directly beneath the second substrate surface.

7. The method of claim 6 wherein forming an antireflective layer stack by ion implantation within the substrate directly beneath the second substrate surface comprises the following first operations:
- providing a first source gas chosen from N₂, O₂, Ar, or He or a mixture thereof,
- ionizing the first source gas so as to form a first mixture of single charge ions and multicharge ions of N, O, Ar, or He or a mixture thereof,
- accelerating the first mixture of single charge ions and multicharge ions of N, O, Ar, or He or a mixture thereof, with a first acceleration voltage so as to form a first beam of single charge ions and multicharge ions, wherein the first acceleration voltage is comprised between 15 kV and 60 kV, and
- positioning the substrates' second surface in the trajectory of the first beam so as to obtain a first ion dosage is comprised between 10¹⁷ ions/cm² and 10¹⁸ ions/cm².

8. The method of claim 6, wherein forming an antireflective layer stack by ion implantation within the substrate directly beneath the second substrate surface further comprises after the first operations the following second operations:
- providing a second source gas chosen from N₂, O₂, Ar, or He or a mixture thereof,
- ionizing the second source gas so as to form a first mixture of single charge ions and multicharge ions of N, O, Ar, or He or a mixture thereof,
- accelerating the second mixture of single charge ions and multicharge ions of N with a second acceleration voltage so as to form a second beam of single charge ions and multicharge ions, wherein the second acceleration voltage is comprised between 15 kV and 60 kV, and
- positioning the substrates' second surface in the trajectory of the second beam so as to obtain a second ion dosage is comprised between 10¹⁷ ions/cm² and 10¹⁸ ions/cm2.

9. The method of any of claims 7 or 8, wherein the sum of all ion dosages is comprised between 2.5 x 10¹⁷ ions/cm² and 7.5 x 10¹⁷ ions/cm².

10. The method of Claim 9, further comprising a final operation of forming the encapsulation material on the second surface of the substrate.
